# EUROPEAN PATENT SPECIFICATION

(11) **EP 3 109 906 B1**
(45) Date of publication and mention of the grant of the patent: **04.11.2020**
(21) Application number: 14877987.9
(22) Date of filing: 04.08.2014
(51) Int. Cl.: H01L 31/049, H01L 31/048

(54) **HUMIDITY-RESISTANT AND HEAT-RESISTANT SOLAR CELL BACKSHEET AND MANUFACTURING METHOD THEREFOR**
FEUCHTIGKEITS- UND HITZEBESTÄNDIGE RÜCKSEITENFOLIE FÜR SOLARZELLEN UND HERSTELLUNGSVERFAHREN DAFÜR
FEUILLE ARRIÈRE DE CELLULE SOLAIRE RÉSISTANTE À L'HUMIDITÉ ET RÉSISTANTE À LA CHALEUR ET SON PROCÉDÉ DE FABRICATION

(30) Priority: 08.01.2014 CN 201410007109
(43) Date of publication of application: 28.12.2016
(73) Proprietor: Suzhou Sunshine New Materials Technology Co., Ltd., Suzhou, Jiangsu 215151 (CN)
(72) Inventor: ZHAO, Ruofei, S6100 AA Echt (NL); CAI, Shuyi, S6100 AA Echt (NL); HUANG, Wei, S6100 AA Echt (NL)
(74) Representative: DSM Intellectual Property
(86) International application number: PCT/CN2014/083604
(87) International publication number: WO 2015/103872

(56) References cited:
- WO-A1-2013/135349
- CN-A- 102 963 090
- CN-A- 102 983 193
- CN-A- 103 715 287
- US-A1- 2010 000 603
- US-A1- 2013 209 795
- US-A1- 2014 000 674

## Description

### Technical field

The present invention relates to the field of photovoltaic electricity generation, in particular to a solar power backsheet.

### Background art

Humans' need for energy is growing steadily, and the current scenario in which traditional energy sources like coal and petroleum take center stage cannot be sustained; the only way to solve the energy challenge humans are facing is to use renewable energy. Photovoltaic electricity generation from solar power is one of the most important renewable energy sources. Countries throughout the world are competing with each other to develop photovoltaic electricity generation from solar power, and to formulate and implement a roadmap for photovoltaic electricity generation. Over the past five years, the global solar power photovoltaic industry has been growing rapidly at a rate of 50% or more, and it is predicted to continue developing at a rate of 30% or more for the next ten years.

Solar power backsheets are widely used in solar cell (photovoltaic) assemblies, being located at the back of solar cell panels, and have the effect of protecting and supporting cells, so must have reliable insulating properties, water resistance and resistance to ageing. Fluoroplastic films have excellent resistance to long-term outdoor ageing, and are used in large quantities to prepare solar cell backsheets. A backsheet mainly comprises a three-layer structure consisting of a weathering-resistant layer, a structural reinforcement layer and a reflective layer; backsheet structures generally used at present include TPT structures and TPE structures, wherein T represents Tedlar film from the company Dupont, with polyvinyl fluoride (PVF) as a constituent, P represents polyethylene terephthalate (PET) film, and E represents ethylene-vinyl acetate resin (EVA) film. Therefore the TPT structure means a PVF film/PET film/PVF film structure, while the TPE structure means a PVF film/PET film/EVA film structure, with the three film layers being bonded by adhesive therebetween. The European company Isovolta is a typical manufacturer of backsheets with the TPT structure. Backsheets with the TPE structure are a patented product of the US company Madico (see patent application WO 2004/091901 A2). At present, there are also some companies that replace PVF film with polyvinylidene fluoride (PVDF) film, to provide a KPK structure and a KPE structure, wherein K represents PVDF film. In addition, there are also some US and Japanese companies which are trying to use ECTFE (ethylene chlorotrifluoroethylene copolymer) and ETFE (ethylene tetrafluoroethylene copolymer) to replace PVF film or PVDF film as a backsheet weather-resistant layer material. The company 3M uses THV (tetrafluoroethylene-hexafluoropropylene-vinylidene fluoride) film to make weather-resistant layers for solar cell backsheets (see patent application US 2006/0280922 A1); the structure thereof is THV/PET/EVA.

Although fluoroplastic film is used in conventional backsheets, and resistance to long-term outdoor ageing is excellent, the cost of the fluoroplastic film itself is high, and this will restrict its use on a larger scale. In addition, the PET film plastic used in the structural reinforcement layer of a conventional backsheet has poor resistance to hydrolysis in hot and humid conditions, so will become brittle and crack when used in a humid and hot environment for a long period of time, leading to deterioration or failure of solar cell performance. Another example of a backsheet for a solar cell module is disclosed in patent publication WO 2013/135349 A1.

### Content of the invention

The present invention overcomes the deficiencies of the prior art by providing a solar cell backsheet which has firm coupling between layers, excellent resistance to ageing in hot and humid conditions and a low cost, and which is of huge significance to the solar power industry.

To achieve the above object, the technical solution employed in the present invention is as defined in claim 1 and comprises: a humidity-resistant and heat-resistant solar cell backsheet, comprising a weather-resistant layer, a connecting layer, a structural reinforcement layer and a reflective layer which are combined sequentially, characterized in that the weather-resistant layer is a biaxially oriented PA weather-resistant film, or made of polyamide (PA), a heat stabilizer, a UV stabilizer and an inorganic material; the structural reinforcement layer is made of polypropylene, modified polypropylene, or an alloy; the alloy is an alloy of polypropylene and an engineering plastic, or an alloy of modified polypropylene and an engineering plastic.

Preferably, the polyamide is one or a combination of more than one selected from the following components: polyamide 6, polyamide 66, polyamide 46, polyamide 610, polyamide 612, polyamide 614, polyamide 613, polyamide 615, polyamide 616, polyamide 11, polyamide 12, polyamide 10, polyamide 912, polyamide 913, polyamide 914, polyamide 915, polyamide 616, polyamide 1010, polyamide 1012, polyamide 1013, polyamide 1014, polyamide 1210, polyamide 1212, polyamide 1213, polyamide 1214, polyamide 6T, polyamide 9T, polyamide 10T, polyamide 12T, adipic adipamide/terephthalic adipamide copolyamide, terephthalic adipamide/isophthalic adipamide copolyamide, poly(adipic acid meta-dimethylbenzamide), terephthalic adipamide/terephthalic 2-methylglutaramide, adipic adipamide/terephthalic adipamide/isophthalic adipamide copolyamide and polycaprolactam-terephthalic adipamide.

Preferably, the melting point of the structural reinforcement layer is higher than 145°C.

Preferably, the modified polypropylene is formed by blending the polypropylene and a heat stabilizer to achieve modification, or formed by blending the polypropylene, grafted polypropylene and a heat stabilizer to achieve modification, or formed by blending the polypropylene, a heat stabilizer and an inorganic filler to achieve modification.

Further preferably, the polypropylene is selected from one or more of homo polypropylene (homo PP), copolypropylene and block copolypropylene.

Further preferably, the modified polypropylene is formed by blending the polypropylene, a heat stabilizer and an inorganic filler to achieve modification. The inorganic filler is selected from one of calcium carbonate, titanium dioxide, barium sulfate, mica, talc, kaolin, glass microbeads and glass fibers.

Preferably, the engineering plastic is polyamide or polyphenylene oxide.

Preferably, the connecting layer is maleic anhydride grafted polyethylene, ethylene acrylic acid copolymer, or ethylene acrylate maleic anhydride terpolymer.

Further preferably, the connecting layer is ethylene/butyl acrylate/maleic anhydride copolymer or maleic anhydride grafted polypropylene.

Preferably, the thickness ratio of the weather-resistant layer, structural reinforcement layer and reflective layer is 20 - 100 : 40 - 400 : 20 - 150.

Preferably, the thickness ratio of the weather-resistant layer, structural reinforcement layer and reflective layer is 30 - 60 : 150 - 300 : 20 - 150.

Preferably, the thickness ratio of the weather-resistant layer, structural reinforcement layer and reflective layer is 50 - 100 : 150 - 250 : 50 - 100.

Preferably, the reflective layer is a polyethylene alloy layer.

The reflective layer is formed by blending polyethylene, a copolymer containing an ethylene segment (-CH₂-CH₂-), a UV stabilizer and an inorganic white pigment to achieve modification.

Further preferably, the reflective layer is formed by blending low-density polyethylene (LLDPE), a copolymer of ethylene and acetic acid (EVA), a UV stabilizer and titanium dioxide (TiO₂) to achieve modification.

Further preferably, the reflective layer is formed by blending low-density polyethylene (LLDPE), ethylene propylene diene monomer (EPDM), a UV stabilizer and titanium dioxide (TiO₂) to achieve modification.

Preferably, the connecting layer is also provided between the structural reinforcement layer and reflective layer, i.e. the solar cell backsheet consists of a weather-resistant layer, a connecting layer, a structural reinforcement layer, a connecting layer and a reflective layer which are combined sequentially.

The present invention also provides the following two methods for manufacturing the solar backsheet.

Method one comprises the following steps:
(1) granulating a weather-resistant layer material, a connecting layer material, a structural reinforcement layer material and a reflective layer material separately by means of an extruder, to obtain weather-resistant layer plastic granules, connecting layer plastic granules, structural reinforcement layer plastic granules and reflective layer plastic granules ready for use;
(2) melting and co-extruding, by means of an extruder, the weather-resistant layer plastic granules, connecting layer plastic granules, structural reinforcement layer plastic granules and reflective layer plastic granules that were prepared in step (1).

Method two comprises the following steps:
(1) granulating a connecting layer material, a structural reinforcement layer material and a reflective layer material separately by means of an extruder, to obtain connecting layer plastic granules, structural reinforcement layer plastic granules and reflective layer plastic granules ready for use;
(2) melting and co-extruding, by means of an extruder, the connecting layer plastic granules, structural reinforcement layer plastic granules and reflective layer plastic granules that were prepared in step (1), and applying to a weather-resistant layer.

The present invention solves the deficiencies in the background art, and has the following beneficial effects:
1. The solar cell backsheet of the present invention replaces the conventional fluorine film material with polyamide (PA) as a weather-resistant layer, so that not only can weather-resistance be ensured, but costs are also greatly reduced. Moreover, replacing the conventional PET material with polypropylene (PP) as a structural reinforcement layer avoids the problem that the conventional PET structural reinforcement layer has poor resistance to hydrolysis in hot and humid conditions, and will become brittle and crack when used in a hot and humid environment for a long period of time, and through cooperation with the PA weather-resistant layer, the backsheet's resistance to ageing in hot and humid conditions can be further increased.
2. As the thickness ratio of the weather-resistant layer, structural reinforcement layer and reflective layer is kept at 20 - 100 : 40 - 400 : 20 - 150, in particular 30 - 60 : 150 - 300 : 20 - 150, or 50 - 100 : 150 - 250 : 50 - 100, the connection between layers is firmer, the structure is more stable, and at the same time, optimum resistance to ageing in hot and humid conditions can be obtained.
3. The backsheet of the present invention may be prepared by melting and co-extrusion of multiple layers, thereby avoiding the conventional adhesive, increasing productivity, and helping to protect the environment.

### Description of the accompanying drawings

The present invention is explained further below in conjunction with the accompanying drawings and embodiments.
Fig. 1 is a structural schematic diagram of embodiment 1 of the present invention;
Fig. 2 is a structural schematic diagram of embodiments 2 - 4 of the present invention;

In the figures: 2 - weather-resistant layer, 4 - first connecting layer, 6 - structural reinforcement layer, 12 - reflective layer; 14 - weather-resistant layer, 16 - first connecting layer, 18 - structural reinforcement layer, 22 - reflective layer, 24 - second connecting layer.

### Particular embodiments

The present invention is now explained in further detail in conjunction with the accompanying drawings and embodiments. These accompanying drawings are all simplified schematic diagrams, which merely illustrate the basic structure of the present invention schematically, and so only show the structure relevant to the present invention.

### Embodiment 1

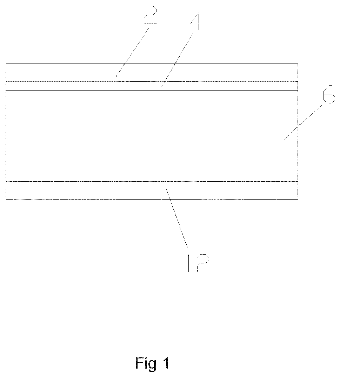

As Fig. 1 shows, a humidity-resistant and heat-resistant solar cell backsheet consists of a weather-resistant layer 2, a first connecting layer 4, a structural reinforcement layer 6 and a reflective layer 12 which are combined sequentially.

The weather-resistant layer 2 is made of polyamide (PA), a heat stabilizer, a UV stabilizer and an inorganic material.

The first connecting layer 4 is maleic anhydride grafted polypropylene.

The structural reinforcement layer 6 has a melting point higher than 145°C, and is made of modified polypropylene. The modified polypropylene is formed by blending homo polypropylene (homo PP) and a heat stabilizer to achieve modification.

The reflective layer 12 is a polyethylene alloy layer. It is formed by blending polyethylene, a copolymer containing an ethylene segment (-CH₂-CH₂-), a UV stabilizer and an inorganic white pigment to achieve modification. More specifically, the reflective layer 12 is formed by blending low-density polyethylene (LLDPE), ethylene propylene diene monomer (EPDM), a UV stabilizer and titanium dioxide (TiO₂) to achieve modification.

The thicknesses of the weather-resistant layer 2, the first connecting layer 4, the structural reinforcement layer 6 and the reflective layer 12 of the backsheet are 50 um, 25 um, 250 um and 50 um, respectively.

### Embodiments 2 - 4

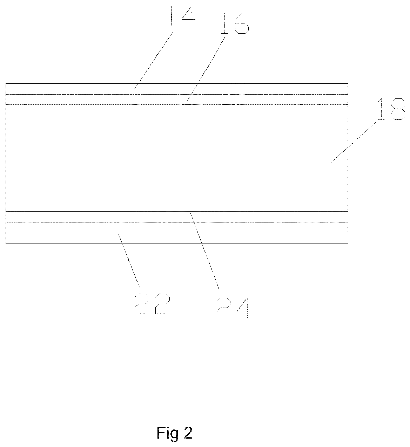

As shown in Fig. 2, a humidity-resistant and heat-resistant solar cell backsheet differs from embodiment 1 in that:
it consists of a weather-resistant layer 14, a first connecting layer 16, a structural reinforcement layer 18, a second connecting layer 24 and a reflective layer 22 which are combined sequentially.

The weather-resistant layer 14 is a biaxially oriented PA weather-resistant film, or made of polyamide (PA), a heat stabilizer, a UV stabilizer and an inorganic material.

The first connecting layer 16 is maleic anhydride grafted polypropylene or ethylene/butyl acrylate/maleic anhydride copolymer.

The structural reinforcement layer 18 has a melting point higher than 145°C, and is made of modified polypropylene or an alloy. The modified polypropylene is formed by blending homo polypropylene (homo PP) and a heat stabilizer to achieve modification, or formed by blending homo polypropylene, grafted polypropylene and a heat stabilizer to achieve modification. The alloy is an alloy of modified polypropylene and an engineering plastic. The engineering plastic is polyamide.

The second connecting layer 24 is the same as the first connecting layer 16.

The thicknesses of the weather-resistant layer 14, the first connecting layer 16, the structural reinforcement layer 18, the second connecting layer 24 and the reflective layer 22 of the backsheet are 50 - 100 um, 15 - 40 um, 150 - 250 um, 15 - 40 um and 100 um, respectively.

See table 1 for specific parameters of the solar backsheets in embodiments 1 - 4.

A first manufacturing method of the present invention is explained below by means of a method for manufacturing the solar backsheets of embodiments 2 - 4, and comprises the following steps:
(1) granulating a first connecting layer material, a second connecting layer material, a structural reinforcement layer material and a reflective layer material separately by means of an extruder, to obtain first connecting layer plastic granules, second connecting layer plastic granules, structural reinforcement layer plastic granules and reflective layer plastic granules ready for use. A weather-resistant layer film is prepared by a method in common use in the art or purchased ready for use.

The first connecting layer material, second connecting layer material, structural reinforcement layer material and reflective layer material are separately prepared by a method in common use in the art according to a formula of the corresponding layer.

(2) Melting and co-extruding, by means of an extruder, the first connecting layer plastic granules, second connecting layer plastic granules, structural reinforcement layer plastic granules and reflective layer plastic granules that were prepared in step (1), and applying to the weather-resistant layer film that was prepared in step (1). The temperature of melting and co-extrusion is 180°C - 310°C, preferably 240°C - 280°C.

A second manufacturing method of the present invention is explained below by means of a method for manufacturing the solar backsheet of embodiment 1, and comprises the following steps:
(1) granulating a weather-resistant layer material, a first connecting layer material, a structural reinforcement layer material and a reflective layer material separately by means of an extruder, to obtain weather-resistant layer plastic granules, first connecting layer plastic granules, structural reinforcement layer plastic granules and reflective layer plastic granules ready for use.
   The weather-resistant layer material, first connecting layer material, structural reinforcement layer material and reflective layer material are separately prepared by a method in common use in the art according to a formula of the corresponding layer.
(2) Melting and co-extruding, by means of an extruder, the weather-resistant layer plastic granules, first connecting layer plastic granules, structural reinforcement layer plastic granules and reflective layer plastic granules that were prepared in step (1) to form a film. The temperature of melting and co-extrusion is 180°C - 310°C, preferably 240°C - 280°C.

If a second connecting layer is also provided between the structural reinforcement layer and the reflective layer, a second connecting layer material can simply be added when melting and co-extrusion are performed in the above preparation method.

To prove the weather resistance and strength of the solar backsheet of the present invention, the following determination experiment is performed thereon. Two backsheets of comparative examples 1 - 2 are selected for comparison. Comparative example 1: an FPE backsheet is made by sequentially combining a conventional PVDF film, a biaxially oriented PET film and an EVA film after applying a polyurethane adhesive, then removing a solvent at a high temperature and curing. Comparative example 2 is made by sequentially combining a weather-resistant PET film, a biaxially oriented PET film and an EVA film after applying a polyurethane adhesive, then removing a solvent at a high temperature and curing. The determination experiment comprises: 1. Test of peel strength between the weather-resistant layer and the structural reinforcement layer (180 degrees, with a peel rate of 0.2 m/min), using an ASTM D1876 standard method; 2. QUV ultraviolet accelerated ageing test (UVA + UVB, 30 kWh/m²), using an IEC61215 standard method, to determine appearance and yellowing; 3. HAST, high-pressure accelerated ageing test machine, appearance after 96 hours of ageing (121°C, 100% humidity), using an ASTM D1868 standard method; 4. Damp-Heat, assembly power attenuation after 3000 hours of ageing (85°C, 85% humidity), using an IEC61215 standard method.

The determination results for comparative examples 1 - 2 and embodiments 1 - 4 are recorded in table 2.

**Table 1**

| | Weather-resistant layer (thickness) | First connecting layer (thickness) | Structural reinforcement layer (thickness) | Second connecting layer (thickness) | Reflective layer (thickness) |
|---|---|---|---|---|---|
| Comparative example 1 (FPE) | PVDF film (25 um) | Polyurethane adhesive (10 um) | Biaxially oriented PET film (250 um) | Polyurethane adhesive (10 um) | EVA film (50 um) |
| Comparative example 2 | PET film (50 um) | Polyurethane adhesive (10 um) | Biaxially oriented PET film (250 um) | Polyurethane adhesive (10 um) | EVA film (50 um) |
| Embodiment 1 | 100 parts PA12, 0.5 parts Tinuvin 770, 0.3 parts Irganox B225 and 10 parts TiO2, blended (50 um) | 100 parts maleic anhydride grafted polypropylene (25 um) | 100 parts homo PP and 0.3 parts Irganox B225, blended (250 um) | | 50 parts LLDPE, 50 parts EPDM, 10 parts TiO2 and 0.5 parts Tinuvin 770, blended (50 um) |
| Embodiment 2 | 100 parts PA6, 0.5 parts Tinuvin 770, 0.3 parts Irganox B225 and 10 parts TiO2, blended (100 um) | 100 parts maleic anhydride grafted polypropylene (40 um) | 100 parts homo PP and 0.3 parts Irganox B225, blended (150 um) | 100 parts maleic anhydride grafted polypropylene (40 um) | 50 parts LLDPE, 50 parts EVA, 10 parts TiO2 and 0.5 parts Tinuvin 770, blended (100 um) |
| Embodiment 3 | 100 parts PA6, 0.5 parts Tinuvin 770, 0.3 parts | 100 parts Lotader 4210 (15 um) | 60 parts homo PP, 30 parts PA6, 10 parts maleic | 100 parts Lotader 4210 (15 um) | 50 parts LLDPE, 50 parts EVA, 10 parts TiO2 |
| | Irganox B225 and 10 parts TiO2, blended (70 um) | | anhydride grafted PP and 0.3 parts Irganox B225, blended (250 um) | | and 0.5 parts Tinuvin 770, blended (100 um) |
| Embodiment 4 | Biaxially oriented PA6 weather-resistant layer (50 um) | 100 parts Lotader 4210 (30 um) | 100 parts co PP and 0.3 parts Irganox B225, blended (150 um) | 100 parts Lotader 4210 (30 um) | 50 parts LLDPE, 50 parts EVA, 10 parts TiO2 and 0.5 parts Tinuvin 770, blended (100 um) |

It must be explained that in table 1: where the corresponding layer has multiple components, the ratio of the components is in parts by weight.

Tinuvin 770 is bis(2,2,6,6-tetramethyl-4-piperidinyl)sebacate, produced by BASF SE. Irganox B225 is a heat stabilizer produced by BASF SE. Lotader 4210 is ethylene/butyl acrylate/maleic anhydride copolymer, produced by the French company Arkema. The backsheet of comparative example 1 is an FPE sheet produced by the Japanese company Toyo Aluminium. In comparative example 2, the PET film is a biaxially oriented weather-resistant film, and specifically may be the biaxially oriented white weather-resistant film with trademark Melinex, produced by the company Dupont Teijin. The polyurethane adhesive is produced by Mitsui Chemicals of Japan, with the trademark A-969V/A-5.

In addition, the polypropylene in the maleic anhydride grafted polypropylene is homo polypropylene.

**Table 2**

| | Peel strength between weather-resistant layer and structural reinforcement layer (N/cm) | QUV, appearance and yellowing in ultraviolet accelerated ageing (30 kWh/m²) | HAST, appearance after 96 hours of ageing (121°C, 100% humidity) | Damp- Heat, assembly power attenuation after 3000 hours of ageing (85°C, 85% humidity) |
|---|---|---|---|---|
| Comparative example 1 (FPE) | 5.1 | Yellowing value 0.1 | Has become brittle and cracked | 23% |
| Comparative example 2 | 0.5 | Yellowing value 0.3 | Has become brittle and cracked | 30% |
| Embodiment 1 | 5.5 | Yellowing value 0.4 | No change | 5% |
| Embodiment 2 | 5.7 | Yellowing value 0.9 | No change | 5% |
| Embodiment 3 | 6.0 | Yellowing value 1.2 | No change | 12% |
| Embodiment 4 | 5.2 | Yellowing value 1.0 | No change | 5% |

It is clear from tables 1 and 2 that the backsheets of embodiments 1 - 4 of the present invention have markedly improved weather resistance compared to the backsheets of comparative examples 1 - 2, while the peel strength can also be maintained at a better level. Clearly, the backsheet of the present invention has strong superiority on account of the combination of the weather-resistant layer and structural reinforcement layer of specific materials.

It must be explained that embodiments 1 - 4 are merely typical solutions selected from the present invention. When the thickness ratio of the weather-resistant layer, structural reinforcement layer and reflective layer of the backsheet of the present invention are kept within the range 20 - 100 : 40 - 400 : 20 - 150, the determination results of the above experiments are all better than comparative examples 1 - 2, and even better in the range 30 - 60 : 150 - 300 : 20 - 150. The specific details will not be repeated. When the weather-resistant layer of the backsheet of the present invention is made from polyamide, a heat stabilizer, a UV stabilizer and an inorganic material by a method in common use in the art, the determination results of the above experiments are all better than comparative examples 1 - 2, and are not limited to the component ratios of the embodiments; the specific details will not be repeated. When the structural reinforcement layer of the backsheet of the present invention is made by a method in common use in the art from polypropylene and a heat stabilizer, or from polypropylene, grafted polypropylene, a heat stabilizer and polyamide, the determination results of the above experiments are all better than comparative examples 1 - 2, and are not limited to the component ratios of the embodiments; the specific details will not be repeated. When the reflective layer of the backsheet of the present invention is made by a method in common use in the art from polypropylene, a copolymer containing an ethylene segment (-CH₂-CH₂-), a UV stabilizer and an inorganic white pigment, the determination results of the above experiments are all better than comparative examples 1 - 2, and are not limited to the component ratios of the embodiments; the specific details will not be repeated.

It must be explained that in the backsheet of the present invention:
1. In the weather-resistant layer, the polyamide is selected from one or more of the following materials: polyamide 6, polyamide 66, polyamide 46, polyamide 610, polyamide 612, polyamide 614, polyamide 613, polyamide 615, polyamide 616, polyamide 11, polyamide 12, polyamide 10, polyamide 912, polyamide 913, polyamide 914, polyamide 915, polyamide 616, polyamide 1010, polyamide 1012, polyamide 1013, polyamide 1014, polyamide 1210, polyamide 1212, polyamide 1213, polyamide 1214, polyamide 6T, polyamide 9T, polyamide 10T, polyamide 12T, adipic adipamide/terephthalic adipamide copolyamide, terephthalic adipamide/isophthalic adipamide copolyamide, poly(adipic acid meta-dimethylbenzamide), terephthalic adipamide/terephthalic 2-methylglutaramide, adipic adipamide/terephthalic adipamide/isophthalic adipamide copolyamide and polycaprolactam-terephthalic adipamide. The inorganic material may be titanium dioxide or barium sulfate; the UV stabilizer and heat stabilizer may employ a corresponding material in common use in the art, which is not limited to the materials used in the embodiments.
2. The first connecting layer may be maleic anhydride grafted polyethylene, ethylene acrylic acid copolymer, or ethylene acrylate maleic anhydride terpolymer. It is not limited to the materials in the embodiments.
3. Apart from the materials in the embodiments, the structural reinforcement layer may also be polypropylene, or an alloy of polypropylene and an engineering plastic. When modified polypropylene is used for the structural reinforcement layer, the modified polypropylene may also be formed by blending polypropylene, a heat stabilizer and an inorganic filler to achieve modification, or formed by blending polypropylene, grafted polypropylene and a heat stabilizer to achieve modification, or formed by adding a heat stabilizer, a UV stabilizer, a toughener and an inorganic filler to polypropylene and blending to achieve modification. The inorganic filler is selected from one of calcium carbonate, titanium dioxide, barium sulfate, mica, talc, kaolin, glass microbeads and glass fibers.
4. In the reflective layer, the copolymer containing an ethylene segment (-CH₂-CH₂-) is selected from one or more of ethylene-acrylic acid copolymer, ethylene-hexene copolymer, ethylene-octene copolymer, ethylene-vinyl acetate copolymer and ethylene acrylate copolymer. The polyethylene, UV stabilizer and inorganic white pigment may be corresponding materials in common use in the art, and are not limited to the embodiments.

The above ideal embodiments according to the present invention serve to enlighten, and relevant persons would absolutely be able to make a variety of changes and amendments, based on the content of the above description, without departing from the scope of the technical thinking of the present invention. The technical scope of the present invention is not limited to the content presented herein, and must be determined according to the scope of the claims.

## Claims

1. A humidity-resistant and heat-resistant solar cell backsheet, comprising a weather-resistant layer [2], a connecting layer [4], a structural reinforcement layer [6] and a reflective layer [12] which are combined sequentially, wherein the weather-resistant layer [2] is a biaxially oriented PA weather-resistant film, or made of polyamide (PA), a heat stabilizer, a UV stabilizer and an inorganic material; wherein the structural reinforcement layer [6] is made of a polypropylene or modified polypropylene or an alloy of polypropylene or modified polypropylene and an engineering plastic, whereby the polypropylene is selected from one or more of homo polypropylene (homo PP), co-polypropylene and block co-polypropylene and whereby the modified polypropylene comprises polypropylene and a heat stabilizer or polypropylene, grafted polypropylene and a heat stabilizer or polypropylene, a heat stabilizer, and an inorganic filler, **characterized in that** the reflective layer [12] is formed by blending polyethylene, a copolymer containing an ethylene segment (-CH2-CH2-), a UV stabilizer and an inorganic white pigment.

2. A humidity-resistant and heat-resistant solar cell backsheet according to claim 1, **characterized in that** the thickness ratio of the weather-resistant layer [2], structural reinforcement layer [6] and reflective layer[12] is 20 - 100: 40 - 400: 20 - 150.

3. A humidity-resistant and heat-resistant solar cell backsheet according to claim 1, **characterized in that** the thickness ratio of the weather-resistant layer [2], structural reinforcement layer [6] and reflective layer [12] is 30 - 60: 150 - 300: 20 - 150.

4. A humidity-resistant and heat-resistant solar cell backsheet according to claim 1, **characterized in that** a connecting layer [24] is also provided between the structural reinforcement layer [6] and reflective layer [12] whereby the solar cell backsheet consists of a weather-resistant layer, a connecting layer, a structural reinforcement layer, a connecting layer and a reflective layer which are combined sequentially.

5. A humidity-resistant and heat-resistant solar cell backsheet according to claim 1, **characterized in that** the melting point of the structural reinforcement layer [6] is higher than 145 degrees C.

6. A humidity-resistant and heat-resistant solar cell backsheet according to claim 1 whereby he inorganic filler is selected from one of calcium carbonate, titanium dioxide, barium sulfate, mica, talc, kaolin, glass microbeads and glass fibers.

7. A humidity-resistant and heat-resistant solar cell backsheet according to claim 1 wherein the engineering plastic is polyamide or polyphenylene oxide.

8. A humidity-resistant and heat-resistant solar cell backsheet according to any one of the claims 1 - 7, **characterized in that** the connecting layer [4, 24] comprises maleic anhydride grafted polypropylene, maleic anhydride grafted polyethylene, ethylene acrylic acid copolymer or ethylene acrylate maleic anhydride terpolymer.

9. A method for manufacturing the humidity-resistant and heat-resistant solar cell backsheet according to any one of claims 1 - 8, **characterized in that** it comprises the following steps:
(1) granulating a weather-resistant layer material, a connecting layer material, a structural reinforcement layer material and a reflective layer material separately by means of an extruder, to obtain weather-resistant layer plastic granules, connecting layer plastic granules, structural reinforcement layer plastic granules and reflective layer plastic granules ready for use;
(2) melting and co-extruding, by means of an extruder, the weather-resistant material granules, connecting material granules, structural reinforcement material granules and reflective material granules that were prepared in step (1).

10. The method for manufacturing the humidity-resistant and heat-resistant solar cell backsheet according to any one of the claims 1 - 8 **characterized by** comprising the following steps:
(1) granulating a connecting layer material, a structural reinforcement layer material and a reflective layer material separately by means of an extruder, to obtain connecting layer plastic granules, structural reinforcement layer plastic granules and reflective layer plastic granules ready for use;
(2) melting and co-extruding, by means of an extruder, the connecting material granules, structural reinforcement material granules and reflective material granules that were prepared in step (1), and applying to a weather-resistant layer.

## Patentansprüche

1. Feuchtigkeitsbeständige und hitzebeständige Solarzellen-Rückseitenfolie, die eine witterungsbeständige Schicht [2], eine Verbindungsschicht [4], eine Schicht zur Strukturverstärkung [6] und eine reflektierende Schicht [12] umfasst, die nacheinander kombiniert werden, wobei die witterungsbeständige Schicht [2] eine biaxial orientierte witterungsbeständige PA-Folie ist oder aus Polyamid (PA), einem Wärmestabilisator, einem UV-Stabilisator und einem anorganischen Material hergestellt ist; wobei die Schicht zur Strukturverstärkung [6] aus einem Polypropylen oder modifiziertem Polypropylen oder einer Kunststofflegierung von Polypropylen oder modifiziertem Polypropylen und einem technischen Kunststoff hergestellt ist, wobei das Polypropylen aus Propylen-Homopolymer (Homo-PP), Propylen-Copolymer und/oder Propylen-Blockcopolymer ausgewählt ist und wobei das modifizierte Polypropylen Polypropylen und einen Wärmestabilisator oder Polypropylen, Propylen-Propfpolymer und einen Wärmestabilisator oder Polypropylen, einen Wärmestabilisator und einen anorganischen Füllstoff umfasst, **dadurch gekennzeichnet, dass**
die reflektierende Schicht [12] durch Vermischen von Polyethylen, einem ein Ethylensegment (-CH₂-CH₂-) enthaltendes Copolymer, einem UV-Stabilisator und einem anorganischen Füllstoff gebildet wird.

2. Feuchtigkeitsbeständige und hitzebeständige Solarzellen-Rückseitenfolie nach Anspruch 1, **dadurch gekennzeichnet, dass** das Dickenverhältnis der witterungsbeständigen Schicht [2], der Schicht zur Strukturverstärkung [6] und der reflektierenden Schicht [12] 20-100:40-400:20-150 beträgt.

3. Feuchtigkeitsbeständige und hitzebeständige Solarzellen-Rückseitenfolie nach Anspruch 1, **dadurch gekennzeichnet, dass** das Dickenverhältnis der witterungsbeständigen Schicht [2], der Schicht zur Strukturverstärkung [6] und der reflektierenden Schicht [12] 30-60:150-300:20-150 beträgt.

4. Feuchtigkeitsbeständige und hitzebeständige Solarzellen-Rückseitenfolie nach Anspruch 1, **dadurch gekennzeichnet, dass** zwischen der Schicht zur Strukturverstärkung [6] und der reflektierenden Schicht [12] auch eine Verbindungsschicht [24] bereitgestellt wird, wodurch die Solarzellen-Rückseitenfolie aus einer witterungsbeständigen Schicht, einer Verbindungsschicht, einer Schicht zur Strukturverstärkung, einer Verbindungsschicht und einer reflektierenden Schicht, die die nacheinander kombiniert werden, besteht.

5. Feuchtigkeitsbeständige und hitzebeständige Solarzellen-Rückseitenfolie nach Anspruch 1, **dadurch gekennzeichnet, dass** der Schmelzpunkt der Schicht zur Strukturverstärkung [6] höher ist als 145 Grad C.

6. Feuchtigkeitsbeständige und hitzebeständige Solarzellen-Rückseitenfolie nach Anspruch 1, wobei der anorganische Füllstoff aus einem von Calciumcarbonat, Titandioxid, Bariumsulfat, Glimmer, Talk, Kaolin, Glasmikrokügelchen und Glasfasern ausgewählt ist.

7. Feuchtigkeitsbeständige und hitzebeständige Solarzellen-Rückseitenfolie nach Anspruch 1, wobei der technische Kunststoff Polyamid oder Polyphenylenoxid ist.

8. Feuchtigkeitsbeständige und hitzebeständige Solarzellen-Rückseitenfolie nach einem der Ansprüche 1-7, **dadurch gekennzeichnet, dass** die Verbindungsschicht [4, 24] Maleinsäureanhydrid-gepfropftes Polypropylen, Maleinsäureanhydrid-gepfropftes Polyethylen, EthylenAcrylsäure-Copolymer oder Ethylen-Acrylat-Maleinsäureanhydrid-Terpolymer umfasst.

9. Verfahren zur Herstellung der feuchtigkeitsbeständigen und hitzebeständigen Solarzellen-Rückseitenfolie nach einem der Ansprüche 1-8, **dadurch gekennzeichnet, dass** es die folgenden Schritte umfasst:
(1) Separates Granulieren eines Materials für eine witterungsbeständige Schicht, eines Materials für eine Verbindungsschicht, eines Materials für eine Schicht zur Strukturverstärkung und eines Materials für eine reflektierende Schicht mittels eines Extruders zum Erhalt gebrauchsfertiger Kunststoffgranulate für eine witterungsbeständige Schicht, Kunststoffgranulate für eine Verbindungsschicht, Kunststoffgranulate für eine Schicht zur Strukturverstärkung und Kunststoffgranulate für eine reflektierende Schicht;
(2) Schmelzen und Coextrudieren der Granulate des witterungsbeständigen Materials, der Granulate des Verbindungsmaterials, der Granulate des Materials zur Strukturverstärkung und der Granulate des reflektierenden Materials, die in Schritt (1) hergestellt wurden, mittels eines Extruders.

10. Verfahren zur Herstellung der feuchtigkeitsbeständigen und hitzebeständigen Solarzellen-Rückseitenfolie nach einem der Ansprüche 1-8, **dadurch gekennzeichnet, dass** es die folgenden Schritte umfasst:
(1) Separates Granulieren eines Materials für eine Verbindungsschicht, eines Materials für eine Schicht zur Strukturverstärkung und eines Materials für eine reflektierende Schicht mittels eines Extruders zum Erhalt gebrauchsfertiger Kunststoffgranulate für eine Verbindungsschicht, Kunststoffgranulate für eine Schicht zur Strukturverstärkung und Kunststoffgranulate für eine reflektierende Schicht;
(2) Schmelzen und Coextrudieren der Granulate des Verbindungsmaterials, der Granulate des Materials zur Strukturverstärkung und der Granulate des reflektierenden Materials, die in Schritt (1) hergestellt wurden, mittels eines Extruders und Aufbringen auf eine witterungsbeständige Schicht.

## Revendications

1. Feuille arrière de cellule solaire résistante à l'humidité et résistante à la chaleur, comprenant une couche résistante aux intempéries [2], une couche de liaison [4], une couche de renforcement structural [6] et une couche réfléchissante [12] qui sont combinées séquentiellement, dans laquelle la couche résistante aux intempéries [2] est un film de PA résistant aux intempéries et orienté biaxialement, ou se compose d'un polyamide (PA), d'un stabilisant thermique, d'un stabilisant aux UV et d'un matériau inorganique ; dans laquelle la couche de renforcement structural [6] se compose d'un polypropylène ou d'un polypropylène modifié ou d'un alliage de polypropylène ou de polypropylène modifié et d'un plastique technique, dans laquelle le polypropylène est sélectionné parmi un ou plusieurs d'un homo-polypropylène (homo-PP), d'un co-polypropylène et d'un co-polypropylène à blocs, et dans laquelle le polypropylène modifié comprend un polypropylène et un stabilisant thermique, ou un polypropylène, un polypropylène greffé et un stabilisant thermique, ou un polypropylène, un stabilisant thermique et une charge inorganique, **caractérisée en ce que** la couche réfléchissante [12] est formée en mélangeant un polyéthylène, un copolymère contenant un segment éthylène (-CH₂-CH₂-), un stabilisant aux UV et un pigment blanc inorganique.

2. Feuille arrière de cellule solaire résistante à l'humidité et résistante à la chaleur selon la revendication 1, **caractérisée en ce que** le rapport d'épaisseur de la couche résistante aux intempéries [2], de la couche de renforcement structural [6] et de la couche réfléchissante [12] est de 20-100:40-400:20-150.

3. Feuille arrière de cellule solaire résistante à l'humidité et résistante à la chaleur selon la revendication 1, **caractérisée en ce que** le rapport d'épaisseur de la couche résistante aux intempéries [2], de la couche de renforcement structural [6] et de la couche réfléchissante [12] est de 30-60:150-300:20-150.

4. Feuille arrière de cellule solaire résistante à l'humidité et résistante à la chaleur selon la revendication 1, **caractérisée en ce qu'**une couche de liaison [24] est également présente entre la couche de renforcement structural [6] et la couche réfléchissante [12], la feuille arrière de cellule solaire consistant ainsi en une couche résistante aux intempéries, une couche de liaison, une couche de renforcement structural, une couche de liaison et une couche réfléchissante, qui sont combinées séquentiellement.

5. Feuille arrière de cellule solaire résistante à l'humidité et résistante à la chaleur selon la revendication 1, **caractérisée en ce que** le point de fusion de la couche de renforcement structural [6] est supérieur à 145 degrés C.

6. Feuille arrière de cellule solaire résistante à l'humidité et résistante à la chaleur selon la revendication 1, dans laquelle la charge inorganique est sélectionnée parmi l'un du carbonate de calcium, du dioxyde de titane, du sulfate de baryum, d'un mica, d'un talc, d'un kaolin, de microbilles de verre et de fibres de verre.

7. Feuille arrière de cellule solaire résistante à l'humidité et résistante à la chaleur selon la revendication 1, dans laquelle le plastique technique est un polyamide ou l'oxyde de polyphénylène.

8. Feuille arrière de cellule solaire résistante à l'humidité et résistante à la chaleur selon l'une quelconque des revendications 1 à 7, **caractérisée en ce que** la couche de liaison [4, 24] comprend un polypropylène greffé d'anhydride maléique, un polyéthylène greffé d'anhydride maléique, un copolymère d'éthylène-acide acrylique ou un terpolymère d'éthylène-acrylate-anhydride maléique.

9. Procédé de fabrication de la feuille arrière de cellule solaire résistante à l'humidité et résistante à la chaleur selon l'une quelconque des revendications 1 à 8, **caractérisé en ce qu'**il comprend les étapes suivantes :
(1) la granulation, séparément, d'un matériau de couche résistante aux intempéries, d'un matériau de couche de liaison, d'un matériau de couche de renforcement structural et d'un matériau de couche réfléchissante au moyen d'une extrudeuse, pour obtenir des granulés de plastique de couche résistante aux intempéries, des granulés de plastique de couche de liaison, des granulés de plastique de couche de renforcement structural et des granulés de plastique de couche réfléchissante, prêts à l'emploi ;
(2) la fusion et la co-extrusion, au moyen d'une extrudeuse, des granulés de matériau résistant aux intempéries, des granulés de matériau de liaison, des granulés de matériau de renforcement structural et des granulés de matériau réfléchissant qui ont été préparés à l'étape (1).

10. Procédé de fabrication de la feuille arrière de cellule solaire résistante à l'humidité et résistante à la chaleur selon l'une quelconque des revendications 1 à 8, **caractérisé en ce qu'**il comprend les étapes suivantes :
(1) la granulation, séparément, d'un matériau de couche de liaison, d'un matériau de couche de renforcement structural et d'un matériau de couche réfléchissante au moyen d'une extrudeuse, pour obtenir des granulés de plastique de couche de liaison, des granulés de plastique de couche de renforcement structural et des granulés de plastique de couche réfléchissante, prêts à l'emploi ;
(2) la fusion et la co-extrusion, au moyen d'une extrudeuse, des granulés de matériau de liaison, des granulés de matériau de renforcement structural et des granulés de matériau réfléchissant qui ont été préparés à l'étape (1), et l'application sur une couche résistante aux intempéries.
